# EUROPEAN PATENT SPECIFICATION

(11) **EP 0 327 023 B1**
(45) Date of publication and mention of the grant of the patent: **05.04.1995**
(21) Application number: 89101636.2
(22) Date of filing: 31.01.1989
(51) Int. Cl.: H01L 27/14, H01L 31/04

(54) **Amorphous silicon thin film solar cell and Schottky barrier diode on a common substrate.**
Dünnschichtsolarzelle aus amorphen Silizium und Schottkykontaktdiode auf einem gemeinsamen Substrat.
Cellule solaire à couche mince en silicium amorphe et diode à barriere Schottky sur un substrat commun.

(30) Priority: 05.02.1988 US 152895
(43) Date of publication of application: 09.08.1989
(73) Proprietor: MINNESOTA MINING AND MANUFACTURING COMPANY, St. Paul, Minnesota 55133-3427 (US)
(72) Inventor: Wenz, Robert P. c/o Minnesota Mining and, P.O. Box 33427 St. Paul Minnesota 55133 (US); Tran, Nang T. c/o Minnesota Mining and, P.O. Box 33427 St. Paul Minnesota 55133 (US)
(74) Representative: Baillie, Iain Cameron

(56) References cited:
- EP-A- 0 078 541
- EP-A- 0 093 513
- DE-A- 3 517 414
- FR-A- 2 577 716
- THIN SOLID FILMS vol. 146, no. 1, January 1987, pages 75-81, Lausanne, CH; M.YANO et al.:"Roll-to- Roll Preparation of a Hydrogenated Amorphous Silicon Solar Cell on a Polymer Film Substrate"
- PATENT ABSTRACTS OF JAPAN vol. 10, no. 69 (E-389)(2126), 18March 1986;& JP - A - 60 218882
- APPL. PHYS. LETT.vol. 39, no. 3, 1 August 1981, pages 274- 276, PaloAlto, ,California, US; M.J.THOMPSON et al.:"Silicide formation in Pd-a-Si:H.Schottky barriers"
- PATENT ABSTRACTS OF JAPAN vol. 9, no. 19 (E-292)(1742), 25 January 1985; &JP - A- 59 165469

## Description

The present invention relates to Schottky barrier thin-film diodes per se and to an amorphous silicon, thin film solar cell and Schottky barrier diode on a common flexible substrate.

Glow-discharge-produced, hydrogenated, amorphous silicon, thin-film, Schottky barrier diodes were first reported by Wronski et al. in an article entitled "Surface States and Barrier Heights of Metal-Amorphous Silicon Schottky Barriers" in Solid State Communications, Vol. 23, 1977, pp. 421-424. Schottky barriers were formed between Al, Ni, Cr, Pd, Au, Rh and Pt metal films and undoped amorphous silicon film. The undoped, hydrogenated, amorphous silicon (a-Si:H) was deposited from a DC discharge in silane onto a substrate held at 320°C to 350°C. These substrates consisted of a three hundred angstrom thick phosphorus-doped a-Si layer on stainless steel which formed an ohmic or a low resistance contact to the undoped amorphous silicon film.

The study of metal-amorphous silicon Schottky barrier thin film diodes continues. In an article entitled "Silicide Formation in Pd-a-Si:H Schottky Barriers" in Appl. Phys. Lett., 39(3), 1 August, 1981, pp. 274-276, Thompson et al reported on amorphous silicon Schottky barrier thin film diodes with palladium. Palladium Schottky barriers were fabricated on quartz substrates. Cr or Ni was deposited to form a bottom electrode, followed by the subsequent deposition of a five hundred angstrom phosphorus doped n⁺a-Si:H layer and an undoped a-Si:H layer having a thickness of .2 to 2.0 micrometers. They obtained a forward current density of 1 x 10⁻² A/cm² at one volt. This appears to be one of the highest forward current densities reported in the literature for metal-amorphous silicon barrier thin film diodes.

Thin film diodes are in widespread use. In general, thin film manufacturing techniques are less expensive and produce higher yields than wafer scale processing techniques used to fabricate crystalline or so-called "discrete" diodes. However, known thin film diodes have characteristics which are poorly suited for many applications. The rigid substrates on which they are fabricated prohibits their use in applications in which the device must be physically deformed. Contaminants from metallic contact layers often react with the semiconductor body during processing, degrading the diode's electrical characteristics. Since they are typically used with other semiconductor devices, the diodes must be separately fabricated and interconnected.

It is evident that there is a continuing need for improved, thin-film Schottky barrier diodes. A diode which can be fabricated using more cost effective, roll-to-roll processing techniques is desired. If a diode of this type were flexible it could be more readily shaped for applications in which planar devices are not suited. Production yields and diode characteristics can be improved if contaminants in the metal layer are isolated during fabrication. Schottky diodes having even larger forward current densities are of course desired. Diodes having these characteristics would be most useful if they could be efficiently fabricated on integrated circuits with other semiconductor devices.

"Thin Solid Films" Vol.146 No.1 Jan 1987 pp 75-81 M. Yano et al discloses an amorphous silicon thin film solar cell comprising:
i) a flexible substrate;
ii) a first conductive layer on the substrate;
iii) an amorphous silicon contact layer forming an ohmic contact to the first conductive layer;
(iv) at least two layers of amorphous silicon forming a pi-n solar cell body in conjunction with the amorphous silicon contact layer and
(v) a second conductive layer on the p-i-n solar cell body.

The invention according to claim 1 provides such an amorphous silicon thin film solar cell characterised by
(vi) a layer of amorphous n-type silicon forming a diode body over a diode portion on the amorphous silicon contact layer, said layer of amorphous n-type silicon being doped to a concentration of 10¹⁸ to 10²⁰ atoms per cubic centimetre with an element from Group V of the Periodic Table, said diode body being adjacent to but spaced from said solar cell body and forming a Schottky barrier with the second conductive layer, and
(vii) insulating material within a separation between the solar cell body and the diode body, the diode body and solar cell body being electrically interconnected by the first conductive layer and ohmic contact layer.

In a preferred embodiment, the substrate is provided as a roll of thin, flexible polyimide substrate having a contact layer which includes a stainless steel bonding layer deposited on the polyimide substrate, an aluminum metal layer deposited on the bonding layer, and a titanium nitride diffusion barrier layer deposited on the aluminum. The solar cell can be made using a roll-to-roll process in a glow-discharge apparatus. The first layer is a layer of n⁺-type silicon. Depositing the second layer includes masking the diode portion. Depositing the third layer includes masking the solar cell portion and depositing a third layer of n-type silicon. Depositing the fourth layer includes masking the diode portion and depositing a fourth layer of p⁺-type silicon. The solar cell and diode portions are separated by laser cutting.

Thin film diodes in accordance with the present invention are well suited to a variety of applications in view of their flexible nature. The n⁺ layer of silicon, which can be doped with phosphorus to a concentration of 10¹⁸ to 10²⁰ atoms per cubic centimeter, results in a high forward current density. Contamination of the semiconductor body by the aluminum during fabrication is prevented by the titanium nitride diffusion barrier.
Production yields and diode characteristics are thereby improved. Furthermore, the diodes can be efficiently interconnected in a circuit and used in conjunction with the solar cells.

The invention also provides a thin-film Schottky barrier diode according to claim 9 comprising a first conductive layer, an n-type first amorphous silicon layer forming an ohmic contact to said first conductive layer, a second amorphous silicon layer on the first amorphous silicon layer and a second conductive layer on said second amorphous silicon layer, said second amorphous silicon layer forming a Schottky barrier with said second conductive layer, characterised in that said second amorphous silicon layer has an n-type conductivity and is doped to a concentration of 10¹⁸ to 10²⁰ atoms per cubic centimetre with an element from the Group V of the Periodic Table.

Figure 1 is a cross-sectional representation of an integrated circuit which includes a solar cell and Schottky Barrier diode in accordance with one embodiment of the present invention.

Figure 2 is a diagrammatic representation, taken from the side, illustrating apparatus used to manufacture the integrated circuit shown in Figure 1.

Figure 3 is a diagrammatic representation, taken from the top, illustrating apparatus used to manufacture the integrated circuit shown in Figure 1.

Figures 4-8 are cross-sectional illustrations of the integrated circuit at intermediate points of manufacture in the apparatus shown in Figures 2 and 3.

Figure 9 is a cross-sectional representation of the integrated circuit at an intermediate point in its manufacture, with a laser separating the diode and solar cell portions.

Figure 10 is a cross-sectional representation of the diode shown in Figure 9, with insulating material applied to the separation between the diode and solar cell portions.

Figure 11 is a cross-sectional representation of an integrated circuit which includes a solar cell and Schottky barrier diode in accordance with a second embodiment of the present invention.

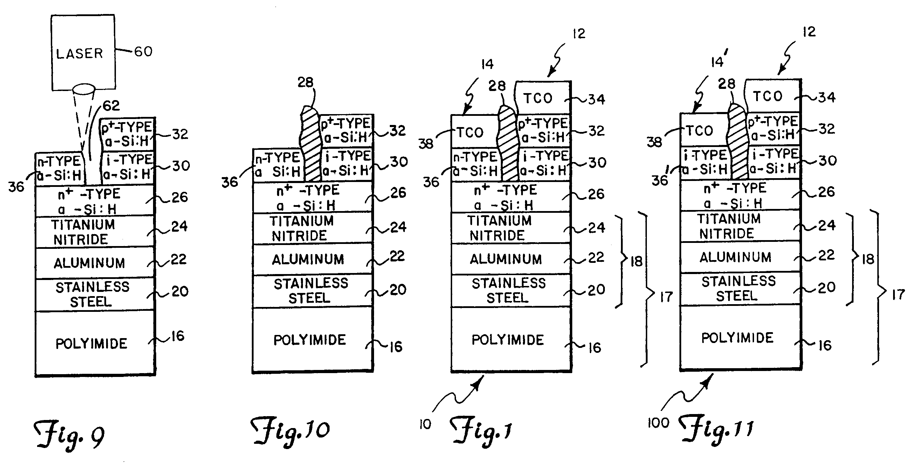

A first embodiment of the present invention, a thin-film monolithic integrated circuit 10 which includes a p-i-n solar cell 12 and Schottky barrier diode 14 fabricated on a common metallized substrate 17, is illustrated generally in Figure 1. Metallized substrate 17 is formed by a metallic (conductive) contact layer 18 which overlies a substrate 16.
Substrate 16 is preferably a thin, flexible and insulating substrate formed from a plastic material such as polyimide or polyester. Polyimide substrates of these types are known and commercially available. In the embodiment shown, metallic contact layer 18 includes a stainless steel bonding layer 20, an aluminum metal layer 22, and a titanium nitride diffusion barrier layer 24. Stainless steel layer 20 strongly bonds to polyimide substrate 16 and provides good adhesion for the remaining layers. Other metals or conductive materials can be used in place of aluminum in layer 22. Titanium nitride (TiN) layer 24 overlies aluminum layer 22 and forms the upper layer of contact layer 18 and metallized substrate 17.

The semiconductor bodies of solar cell 12 (i.e. the solar cell portion of integrated circuit 10) and diode 14 (diode portion) have in common a first layer 26 of n⁺-type hydrogenated amorphous silicon (a first conductivity type semiconductor having a first conductivity value). First layer 26 of hydrogenated amorphous silicon (a-Si:H) overlies titanium nitride diffusion barrier layer 24 and forms an ohmic contact between metallic contact layer 18 and the semiconductor bodies of solar cell 12 and diode 14. As shown in Figure 1, solar cell 12 and diode 14 are adjacent to one another on integrated circuit 10, and separated by an epoxy insulating wall or strip 28. The body of p-i-n solar cell 12 also includes a second layer 30 of intrinsic-type (i-type) hydrogenated amorphous silicon which overlies silicon layer 26, and a p⁺-type layer 32 of hydrogenated amorphous silicon (a second conductivity type material having a second conductivity value) overlying layer 30. A contact layer 34 of conductive material overlies layer 32. In the embodiment shown, contact layer 34 is formed by a top conducting oxide (TCO) layer which forms an ohmic contact with silicon layer 32. The top electrode can also be formed using metals for contact layer 34, as is well known in the art.

The body of Schottky diode 14 also includes an n-type layer 36 of hydrogenated amorphous silicon (the first conductivity type material having a third conductivity value) which overlies layer 26. A TCO contact layer 38 overlies layer 36. In one embodiment layer 36 is a layer of intrinsic silicon which is slightly doped with phosphorus to a concentration of approximately 10¹⁸ to 10²⁰ atoms per cubic centimeter (PH₃/SiH₄ = 1 x 10⁻⁴, or less than one-tenth of one percent, in the gas phase). Other group V elements can also be used for doping. Conducting oxide layer 38 is a conductive material which forms a Schottky barrier with n-type silicon layer 36. As is well known, metals or other conducting materials can be used in layer 36 to form Schottky barriers.

Integrated circuit 10 and Schottky diode 14 have advantageous features over those known in the art. Since integrated circuit 10 is formed on a flexible substrate, roll-to-roll processes such as those described below can be used for large area and cost effective manufacture. Unlike single crystal devices, the diode and solar cell are compact and resilient -- not fragile. The flexible nature of the circuit enables it to be shaped as needed for individual applications. Since diode 14 is fabricated on the same substrate as solar cell 12, these two devices can be efficiently interconnected to form electric circuits. In one embodiment a plurality of diodes 14 are coupled in series as blocking diodes with a series arrangement of solar cells 12. All of these devices can be fabricated on a common substrate using the methods disclosed herein. The use of titanium nitride as a diffusion barrier prevents contaminants from the aluminum metal layer from reacting with the amorphous silicon body of the solar cell and diode during fabrication. Titanium nitride is inert during normal deposition, yet will not detrimentally affect current flow between the layers of aluminum and silicon.

The use of slightly doped silicon layer 36 in diode 14 has been found to reduce the forward biased threshold voltage of diode 14, while increasing its forward current density. These advantages are achieved without severely reducing the reverse breakdown voltage of diode 14. Forward current densities greater than one ampere per square centimeter have been observed in experiments. This current density is one hundred times larger than reported state-of-the-art current densities. The diode also has a threshold voltage of 0.15 to 0.20 volt, which is the same as that for single crystal silicon Schottky diodes.

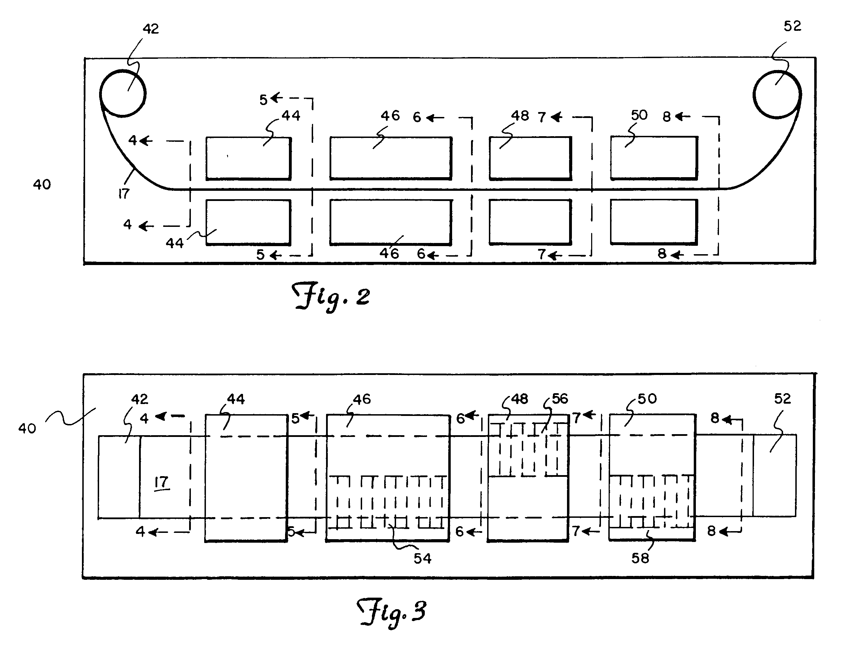

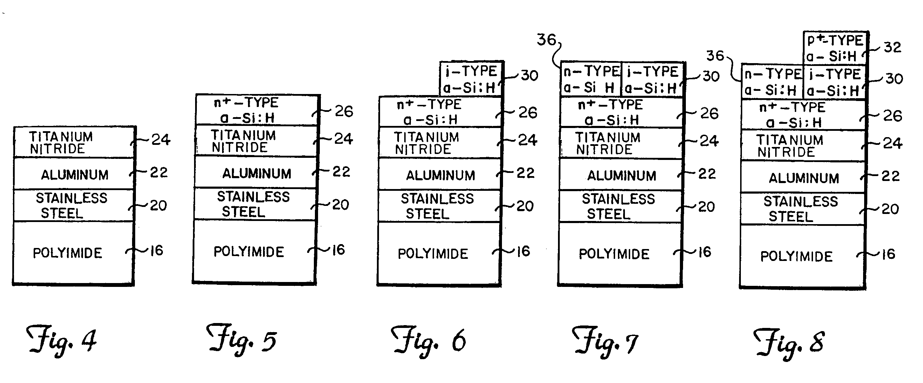

A method for fabricating integrated circuit 10 is described with reference to Figures 2-10. As shown in Figures 2 and 3, integrated circuit 10 is manufactured using a roll-to-roll process carried out within main vacuum chamber 40. A feed roll 42 of metallized substrate 17 is positioned within main vacuum chamber 40. An end of metallized substrate 17 is then passed through a series of miniature vacuum chambers 44, 46, 48 and 50, before being wound onto takeup roll 52. In preferred embodiments the roll of metallized substrate 17 will have been fabricated to include the polyimide substrate 16 and metallization layer 18 illustrated in Figure 1. Stainless steel layer 20, aluminum layer 22 and titanium nitride layer 24 can be deposited on substrate 16 in any known or conventional manner, such as sputtering. In one embodiment aluminum layer 22 has a thickness of one thousand to three thousand angstroms, and titanium nitride layer 24 has a thickness of one hundred to three hundred angstroms. Layer 20 of stainless steel has a thickness of fifty to two hundred angstroms. In still other embodiments, polyimide substrate 16 is encapsulated or surrounded by stainless steel in accordance with the method described in the copending application entitled "Sealing of Polyimide Film", filed on even date. Metallized substrate 17 can also be cleaned utilizing known glow discharge techniques (not shown) before entering vacuum chamber 44. A cross-sectional representation of metallized substrate 17 as it leaves roll 42, and before it enters vacuum chamber 44, is illustrated in Figure 4.

Silicon layer 26 is deposited on metallized substrate 17 as it passes through vacuum chamber 44. This film is deposited on all portions of the substrate over which it is desired to fabricate diodes 14 and solar cells 12 in accordance with the present invention. In one embodiment, the silicon is phosphorus doped and deposited to a thickness of 20nm to 40nm preferably 30 nm (two hundred to four hundred, and preferably three hundred angstroms). A cross-section of metallized substrate 17 having silicon layer 26 deposited thereon is illustrated in Figure 5.

After leaving vacuum chamber 44, the metallized substrate with deposited layer 26 enters vacuum chamber 46. As illustrated diagrammatically in Figure 3, a mask 54 is mounted within chamber 46 above a portion of the substrate upon which Schottky diode 14 is to be fabricated. Layer 30 of intrinsic-type silicon is then deposited only on a section of metallized substrate 17 over which it is desired to form solar cell 12. Silicon layer 30 can be deposited to a thickness of 300 to 700 nm, preferably 550 nm (three thousand to seven thousand angstroms, and preferably to a thickness of five thousand and five hundred angstroms). A cross-sectional representation of the metallized substrate 17 with deposited layers 26 and 30 is illustrated in Figure 6.

The metallized substrate with layers 26 and 30 next enters vacuum chamber 48. As illustrated in Figure 3, vacuum chamber 48 has a mask 56 positioned adjacent a portion of metallized substrate 17 over which solar cell 14 is to be fabricated. An n-type film or layer 36 of silicon is then deposited over the portion of the substrate on which diode 14 is to be fabricated. A cross-sectional representation of metallized substrate 17 with layers 26, 30 and 36 deposited thereon is shown in Figure 7. N-type silicon layer 36 can be deposited to a thickness of 300 to 1000 nm (three thousand to ten thousand Angstroms). Layer 36 is deposited to a thickness of 500 nm (five thousand Angstroms) in one preferred embodiment.

After emerging from vacuum chamber 48, metallized substrate 17 with deposited layers 26, 30, and 36 enters vacuum chamber 50. As shown diagrammatically in Figure 3, a mask 58 is positioned within vacuum chamber 50 above a portion of metallized substrate 17 over which Schottky diode 14 is to be fabricated. A p⁺-type silicon layer 32 is thereby deposited above silicon layer 30. Layer 32 can be deposited to a thickness of 10 to 20 nm (one hundred to two hundred Angstroms), and preferably to a thickness of 15 nm (one hundred and fifty angstroms). A cross-sectional representation of metallized substrate 17 having the silicon layers 26, 30, 32 and 36 deposited thereon is illustrated in Figure 8. Metallized substrate 17 with silicon layers 26, 30, 32 and 36 is wound onto takeup reel 52 after leaving chamber 50. Although only one diode 14 and solar cell 12 are shown in Figures 1 and 4-8 for purposes of this example, it will be appreciated that a plurality of diodes 14 and solar cells 12 can be formed on metallized substrate 17 using the masking procedures described herein.

The roll of metallized substrate 17 with deposited layers 26, 30, 32 and 36 is next removed from takeup reel 52 and further processed to separate silicon layers 30 and 36 from one another above layer 26. As illustrated in Figure 9, this separation can be performed using a laser 60 which cuts a gap 62 between layers 30 and 36. Gap 62 is then filled to a point, above layer 32 with an insulating substance such as epoxy 64. The integrated circuit in this intermediate stage of fabrication is illustrated in Figure 10.

Finally, top conducting oxide layers 34 and 38 (or other metallic substances) are applied to silicon layers 30 and 32, respectively, in a known or conventional manner. Utilizing these fabrication steps, integrated circuit 10 is formed with thin film solar cell 12 and Schottky barrier diode 14 positioned adjacent one another. Solar cell 12 and diode 14 are electrically interconnected by metallic contact layer 18. It is also evident that a plurality of diodes 14 and solar cells 12 can be formed adjacent one another utilizing this method. The above described processing steps can be performed in conventional capacitance radio frequency (RF) glow discharge apparatus. Other techniques such as photochemical vapor deposition can also be used. Silane, hydrogen and phosphine can be used as gases. During fabrication, substrate 16 can be maintained at a temperature within the range of 200-300°C, and preferably at 250°C. The RF power density can be in the range of 0.01 to 0.1 watts per square centimeter, and is 0.037 watts per square centimeter in one preferred embodiment. The pressure can be kept at 33 Pa to 200 Pa (0.25 to 1.5 Torr), and is 133 Pa (1.0 Torr) in a preferred embodiment.

Further processing of integrated circuit 10 is required prior to its intended use. In one embodiment, integrated circuit 10 can be wrapped around a battery (not shown) to provide continuous charging. In this embodiment, integrated circuit 10 will be fabricated to include a plurality of solar cells 12 adjacent one another and connected in a series arrangement. Metal bus bars (not shown) can be used to interconnect solar cells 12 and diodes 14. Solar cells 12 and diodes 14 can, for example, be interconnected in a manner described in US-A-4 873 201 entitled "Interconnected Semiconductor Devices". When integrated circuit 10 is used in this manner, Schottky diodes 14 can be connected in series and used as blocking diodes to prevent discharge of the battery through solar cell 12. Diodes such as 14 can also be used in conjunction with solar cells 12 as "bypass" diodes. Any conventional and known technique can be used to interconnect diode 14 to solar cell 12.

A second preferred embodiment of the present invention, integrated circuit 100, is illustrated in Figure 11. Integrated circuit 100 is similar to that of integrated circuit 10 previously described, and identical reference symbols are used to describe identical portions. Integrated circuit 100 includes p-i-n solar cell 12 fabricated adjacent to a Schottky barrier diode 14′ on a common metallized substrate 17. As is evident, the only difference between diode 14′ and diode 14 is that a layer 36′ of intrinsic-type hydrogenated amorphous silicon is deposited on silicon layer 26 in integrated circuit 100, as opposed to the n-type silicon layer 36 of diode 10. Integrated circuit 100 can be fabricated using the method described with reference to Figures 2-10 by removing mask 54 within miniature chamber 46, and omitting the deposition carried out in chamber 48. Diode 14′ of integrated circuit 100 will not have the increased forward current density and associated advantages of diode 14 which result from the n-type silicon of layer 36.

## Claims

1. An amorphous silicon thin-film solar cell comprising:
i) a flexible substrate (16);
ii) a first conductive layer (18) on the substrate;
iii) an amorphous silicon contact layer (26) forming an ohmic contact to the first conductive layer;
(iv) at least two layers (30,32) of amorphous silicon forming a p-i-n solar cell body in conjunction with the amorphous silicon contact layer (26) over a solar cell portion (12) and
(v) a second conductive layer (34) on the p-i-n solar cell body
characterised by:
(vi) a layer (36,36′) of amorphous n-type silicon forming a diode body over a diode portion (14) on the amorphous silicon contact layer (26), said layer (36,36′) of amorphous n-type silicon being doped to a concentration of 10¹⁸ to 10²⁰ atoms per cubic centimetre with an element from Group V of the Periodic Table, said diode body being adjacent to but spaced from said solar cell body and forming a Schottky barrier with a second conductive layer (38) formed over said diode portions (14), and
(vii) insulating material (28) within a separation between the solar cell body and the diode body, the diode body and solar cell body being electrically interconnected by the first conductive layer (18) and ohmic contact layer (26).

2. A solar cell according to claim 1 wherein the substrate (16) is a thin, flexible and plastic substrate.

3. A solar cell according to claim 2 wherein the substrate (16) is composed of polyimide.

4. A solar cell according to any preceding claim wherein the first conductive layer (18) includes a metal layer (20) deposited over the substrate (16) and a titanium nitride diffusion barrier layer (24) deposited on the metal layer.

5. A solar cell according to claim 4 wherein the metal layer (20) includes a layer (22) of aluminium.

6. A solar cell according to claim 4 or claim 5 wherein the titanium nitride diffusion barrier (24) is deposited to a thickness in the range of 10 to 30 nanometres (one hundred to three hundred Angstroms).

7. The solar cell according to any preceding claim wherein the layer (36) of n-type silicon is doped with phosphorus.

8. A solar cell according to any preceding claim wherein the amorphous silicon contact layer (26) includes a layer of n⁺-type silicon deposited on the first conductive layer (18).

9. A thin-film Schottky barrier diode formed on a common flexible substrate with an amorphous silicon thin-film solar cell, said barrier diode comprising a first conductive layer (18), an n-type first amorphous silicon layer (26) forming an ohmic contact to said first conductive layer, a second amorphous silicon layer (36) on the first amorphous silicon layer and a second conductive layer (38) on said second amorphous silicon layer, said second amorphous silicon layer forming a Schottky barrier with said second conductive layer, characterised in that said second amorphous silicon layer has an n-type conductivity and is doped to a concentration of 10¹⁸ to 10²⁰ atoms per cubic centimetre with an element from the Group V of the Periodic Table.

10. A Schottky barrier diode according to claim 9 wherein said Group V element is phosphorus.

## Patentansprüche

1. Dünnfilmsolarzelle aus amorphem Silicium, umfassend:
(i) ein flexibles Substrat (16);
(ii) eine erste Leitschicht (18) auf dem Substrat;
(iii) eine amorphe Silicium-Kontaktschicht (26), die zur ersten Leitschicht einen ohmschen Kontakt bildet;
(iv) mindestens zwei Schichten (30,32) von amorphem Silicium, die in Verbindung mit der amorphen Silicium-Kontaktschicht (26) über einem Solarzellen-Abschnitt (12) einen pin-Solarzellen-Teil bildet; und
(v) eine zweite Leitschicht (34) auf dem pin-Solarzellen-Teil,
gekennzeichnet durch:
(vi) eine Schicht (36, 36′) von amorphem n-leitendem Silicium, die über einen Dioden-Abschnitt (14) auf der amorphen Silicium-Kontaktschicht (26) einen Dioden-Teil bildet, wobei die Schicht (36, 36′) von amorphem n-leitendem Silicium auf eine Konzentration von 10¹⁸ ... 10²⁰ Atomen pro Kubikzentimeter mit einem Element der Gruppe V des Periodensystems dotiert ist, wobei der an dem Solarzellen-Teil angrenzende Dioden-Teil von diesem jedoch beabstandete ist und eine Schottky-Barriere mit einer zweiten Leitschicht (38) bildet, die über dem Dioden-Abschnitt (14) gebildet wird; sowie
(vii) Isoliermaterial (28) im Inneren einer Separation zwischen dem Solarzellen-Teil und dem Dioden-Teil, wobei der Dioden-Teil und der Solarzellen-Teil über die erste Leitschicht (18) und die ohmsche Kontaktschicht (26) elektrisch miteinander verbunden sind.

2. Solarzelle nach Anspruch 1, bei welcher das Substrat (16) ein dünnes flexibles Kunststoffsubstrat ist.

3. Solarzelle nach Anspruch 2, bei welcher das Substrat (16) aus Polyimid zusammengesetzt ist.

4. Solarzelle nach einem der vorgenannten Ansprüche, bei welcher die erste Leitschicht (18) eine über dem Substrat (16) abgeschiedene Metallschicht (20) und eine auf der Metallschicht abgeschiedene Titaniumnitrid-Diffusionssperrschicht (24) einschließt.

5. Solarzelle nach Anspruch 4, bei welcher die Metallschicht (20) eine Schicht (22) aus Aluminium einschließt.

6. Solarzelle nach Anspruch 4 oder 5, bei welcher die Titaniumnitrid-Diffusionssperrschicht (24) bis zu einer Dicke im Bereich von 10 ... 30 Nanometern (1/100 ... 3/100 Å) abgeschieden wird.

7. Solarzelle nach einem der vorgenannten Ansprüche, bei welcher die Schicht (36) mit Phosphor dotiertes, n-leitendes Silicium ist.

8. Solarzelle nach einem der vorgenannten Ansprüche, bei welcher die amorphe Silicium-Kontaktschicht (26) eine auf der ersten Leitschicht (18) abgeschiedene n-leitende Siliciumschicht einschließt.

9. Schottky-Dünnfilmdiode, gebildet mit einer Dünnfilmsolarzelle aus amorphem Silicium auf einem gemeinsamen flexiblen Substrat, welche Schottky-Diode aufweist: eine erste Leitschicht (18); eine auf der ersten Leitschicht einen ohmschen Kontakt bildende erste amorphe, n-leitende Siliciumschicht (26); eine zweite amorphe Siliciumschicht (36) auf der ersten amorphen Siliciumschicht sowie eine zweite Leitschicht (38) auf der zweiten amorphen Siliciumschicht, welche zweite amorphe Siliciumschicht mit der zweiten Leitschicht eine Schottky-Barriere bildet, dadurch gekennzeichnet, daß die zweite amorphe Siliciumschicht eine n-Leitfähigkeit hat und mit einem Element der Gruppe V des Periodensystems bis zu einer Konzentration von 10¹⁸ ... 10²⁰ Atomen pro Kubikzentimeter dotiert ist.

10. Schottky-Diode nach Anspruch 9, bei welcher das Element der Gruppe V Phosphor ist.

## Revendications

1. Cellule solaire en couche mince en silicium amorphe comprenant :
(i) un substrat flexible (16),
(ii) une première couche conductrice (18) sur le substrat,
(iii) une couche de contact en silicium amorphe (26) formant un contact ohmique avec la première couche conductrice,
(iv) au moins deux couches (30, 32) en silicium amorphe formant un corps de cellule solaire PIN en combinaison avec la couche de contact en silicium amorphe (26) par-dessus une partie de cellule solaire (12) et
(v) une seconde couche conductrice (34) sur le corps de cellule solaire PIN, caractérisée par :
(vi) une couche (36, 36′) en silicium amorphe de type n formant un corps de diode par-dessus une partie de diode (14) sur la couche de contact (26) en silicium amorphe, ladite couche (36, 36′) en silicium amorphe de type n étant dopée à une concentration de 10¹⁸ à 10²⁰ atomes par centimètre cube avec un élément du Groupe V de la Table Périodique, le corps de diode étant adjacent au corps de cellule solaire, mais espacé de ce dernier, et formant une barrière de Schottky avec une seconde couche conductrice (38) formée par-dessus ladite partie de diode (14), et
(vii) une matière isolante (28) placée dans une séparation située entre le corps de cellule solaire et le corps de diode, le corps de diode et le corps de cellule solaire étant électriquement interconnectés par la première couche conductrice (18) et la couche de contact ohmique (26).

2. Cellule solaire selon la revendication 1, dans laquelle le substrat (16) est un substrat en matière plastique mince et flexible.

3. Cellule solaire selon la revendication 2, dans laquelle le substrat (16) est composé de polyimide.

4. Cellule solaire selon l'une quelconque des revendications précédentes, dans laquelle la première couche conductrice (18) comprend une couche métallique (20) déposée par-dessus le substrat (16) et une couche de barrière de diffusion (24) en nitrure de titane déposée sur la couche métallique.

5. Cellule solaire selon la revendication 4, dans laquelle la couche métallique (20) comprend une couche (22) en aluminium.

6. Cellule solaire selon la revendication 4 ou la revendication 5, dans laquelle la barrière de diffusion (24) en nitrure de titane est déposée sous une épaisseur comprise entre 10 et 30 nanomètres (cent et trois cents angströms).

7. Cellule solaire selon l'une quelconque des revendications précédentes, dans laquelle la couche (36) en silicium de type n est dopée avec du phospore.

8. Cellule solaire selon l'une quelconque des revendications précédentes, dans laquelle la couche de contact (26) en silicium amorphe comprend une couche de silicium de type n+ déposée sur la première couche conductrice (18).

9. Diode à barrière de Schottky en couche mince, formée sur un substrat flexible commun avec une cellule solaire en couche mince en silicium amorphe, la diode à barrière comprenant une première couche conductrice (18), une première couche (26) en silicium amorphe de type n formant un contact ohmique avec la première couche conductrice, une seconde couche (36) en silicium amorphe sur la première couche en silicium amorphe et une seconde couche conductrice (38) sur la seconde couche en silicium amorphe, la seconde couche en silicium amorphe formant une barrière de Schottky avec la seconde couche conductrice, caractérisée en ce que la seconde couche en silicium amorphe a une conductivité de type n et est dopée à une concentration de 10¹⁸ à 10²⁰ atomes par centimètre cube avec un élément du Groupe V de la Table Périodique.

10. Diode à barrière de Schottky selon la revendication 9, dans laquelle l'élément du Groupe V est le phosphore.
